# EUROPEAN PATENT SPECIFICATION

(11) **EP 4 576 206 B1**
(45) Date of publication and mention of the grant of the patent: **26.08.2026**
(21) Application number: 23864423.1
(22) Date of filing: 28.06.2023
(51) Int. Cl.: H10W 70/65, H10W 70/685, H10W 90/00, H10W 70/69

(54) **SUBSTRATE, ENCAPSULATION STRUCTURE, AND ELECTRONIC DEVICE**
SUBSTRAT, VERKAPSELUNGSSTRUKTUR UND ELEKTRONISCHE VORRICHTUNG
SUBSTRAT, STRUCTURE D'ENCAPSULATION ET DISPOSITIF ÉLECTRONIQUE

(30) Priority: 16.09.2022 CN 202211131445
(43) Date of publication of application: 25.06.2025
(73) Proprietor: Huawei Technologies Co., Ltd., Shenzhen, Guangdong 518129 (CN)
(72) Inventor: FAN, Dailiang, Shenzhen, Guangdong 518129 (CN); YANG, Kaiqiang, Shenzhen, Guangdong 518129 (CN)
(74) Representative: Goddar, Heinz J.
(86) International application number: PCT/CN2023/103205
(87) International publication number: WO 2024/055684

(56) References cited:
- CN-A- 104 952 746
- JP-A- 2011 096 819
- US-A- 6 118 182
- US-A1- 2002 104 874
- US-A1- 2002 104 874
- US-A1- 2010 071 950
- US-A1- 2020 203 299
- US-B1- 6 365 978

## Description

### TECHNICAL FIELD

Embodiments of this application relate to the field of chip packaging technologies, and in particular, to a substrate, a packaging structure, and an electronic device.

### BACKGROUND

As electronic products become increasingly intelligent in functions and increasingly miniaturized in sizes, chips in the electronic products become increasingly complex. A ball grid array (BGA) packaged chip has become a mainstream of packaged components, because the BGA packaged chip has high I/O density and may be directly disposed on a circuit board by using a surface mount technology (SMT). Because a package size of the BGA packaged chip is increasingly large, and a chip technology also enters a bottleneck period, a solder joint of the BGA packaged chip may experience fatigue cracking after long-term use, thereby affecting reliability of the chip. Especially in high reliability and extreme environment scenarios, fatigue cracking of a solder joint has become a problem that needs to be urgently resolved.

For BGA packaged chips, high-risk regions for solder joint reliability are generally concentrated at four corners of chip packaging. In a related technology, adjacent pads with a same attribute are generally used at the four corners for connection, or a large pad is disposed to increase a soldering area, so that strength of a solder joint can be increased, and reliability of the solder joint can be improved.

However, because a size of the enlarged pad is different from a size of a conventional pad, it cannot be ensured that a solder ball is consistent with a conventional solder ball during ball placement. Collapse of the solder ball causes a height of the solder ball to be different from a height of another conventional solder ball, that is, it is difficult to control and ensure coplanarity, thereby causing poor soldering. In addition, irregular shapes of solder balls at the four corners also affect identification of a surface-mount device.
US 2002/104874 A1 discloses a semiconductor chip package that includes a semiconductor chip mounted on a top surface of a substrate. A bottom surface of the substrate has ball pads. Bonding pads of the chip are electrically connected to the substrate. Enhanced pads, each having one or more dummy patterns coupled to one or more dummy pads, are preferably formed near edges of the substrate. The semiconductor chip package is mounted on the board by attaching external connection terminals such as solder balls, formed on the ball pads and the dummy pads, to a solder paste coated on ball lands and enhanced lands of the board.
JP 2011 096819 A discloses a semiconductor apparatus having a plurality of electrode lands for connection with a circuit board on a backside of a substrate, a reinforcement land provided on an outer periphery of the backside of the substrate, and an over-resist part on which a solder resist is applied to coat a part on the reinforcement land. Each of a plurality of openings not coated by the over-resist part on the reinforcement land has shape and size substantially the same as those of the electrode lands.
US 2010/071950 A1 discloses a wiring board that is comprised of a plurality of circular semiconductor element connection pads deposited in a lattice form onto a mounting portion of an insulation substrate, their upper surfaces being connected to electrodes of a semiconductor element, and a solder resist layer deposited onto the insulation substrate, which covers the side surfaces of these pads and exposes the upper surfaces of these pads. The solder resist layer has a concave part whose bottom surface corresponds to at least all the upper surfaces of these pads.
US 2020/203299 A1 discloses a method for forming a chip package structure. The method includes bonding a chip to a first surface of a first substrate. The method includes forming a dummy bump over a second surface of the first substrate. The first surface is opposite the second surface, and the dummy bump is electrically insulated from the chip. The method includes cutting through the first substrate and the dummy bump to form a cut substrate and a cut dummy bump. The cut dummy bump is over a corner portion of the cut substrate, a first sidewall of the cut dummy bump is substantially coplanar with a second sidewall of the cut substrate, and a third sidewall of the cut dummy bump is substantially coplanar with a fourth sidewall of the cut substrate.

### SUMMARY

Embodiments of this application provide a substrate, a packaging structure, and an electronic device, to resolve at least a problem of fatigue cracking of a solder joint in a related technology. The invention provides a substrate according to claim 1 and a packaging structure of claim 9. Further embodiments are disclosed in the dependent claims. In the following description, embodiments nor covered by the claims shall be considered as examples helpful for understanding the invention.

One aspect of embodiments of this application provides a substrate of claim 1, including: a base body and a barrier layer disposed on a surface of the base body, where a first metal layer and a plurality of second metal layers arranged in an array are disposed between the base body and the barrier layer, and the first metal layer is disposed near at least a part of the second metal layers on an outer side of the array. A first hollow-out region is provided at a position that is of the barrier layer and that is opposite to the first metal layer, and at least a part of the first metal layer is exposed in the first hollow-out region. A second hollow-out region is provided at a position that is of the barrier layer and that is opposite to each second metal layer, at least a part of the second metal layer is exposed in the second hollow-out region, the second hollow-out regions are separated from each other, and the first hollow-out region is separated from an adjacent second hollow-out region.

In the substrate provided in this embodiment of this application, in a process in which the substrate is soldered to a circuit board after balls (solder balls) are placed, because the first hollow-out region is disposed near the second hollow-out region, the barrier layer between the first hollow-out region and the second hollow-out region is relatively narrow, and the solder balls collapse under pressure of the substrate due to a weight. In addition, in cooperation of an amount of solder printed on the circuit board, and the solder may easily cross the barrier layer and be spread onto the first metal layer, thereby forming a larger soldering area to improve solder joint reliability. In addition, because the substrate provided in this embodiment of this application may implement the larger soldering area, the second hollow-out regions electrically connected to the solder balls may be disposed as regions with an equal hollow-out area. The second hollow-out regions are separated from each other and are separated from the first hollow-out region. After the prefabricated solder balls are attached to the second hollow-out regions and soldered to the second metal layers through reflow soldering, it may be ensured that shapes of the solder balls are the same, and a purpose of same coplanarity of the solder balls may be achieved. Moreover, when the substrate provided in this embodiment of this application is manufactured, opening shapes of the first hollow-out region and the second hollow-out region may be preset, and machining of the barrier layer is completed by using a conventional solder mask layer machining process, thereby avoiding addition of an additional procedure and an increase in management and control difficulty.

In a possible implementation, the barrier layer has at least one barrier ring, the barrier ring is located between the first hollow-out region and the adjacent second hollow-out region, and the first hollow-out region is separated from the adjacent second hollow-out region by the barrier ring. The barrier ring with a regular form and a same width is disposed between the first hollow-out region and the adjacent second hollow-out region. In comparison with a barrier material with an irregular form disposed between the first hollow-out region and the adjacent second hollow-out region, in a process of soldering the substrate to the circuit board, solder may more easily and evenly cross the barrier material between the first hollow-out region and the second hollow-out region and be spread onto the first metal layer, thereby more effectively increasing a soldering area to improve solder joint reliability.

In a possible implementation, the at least one barrier ring is a 360° annular structure, and an inner side of the annular structure encloses one second hollow-out region adjacent to the first hollow-out region.

The at least one barrier ring is a semi-ring structure, and an inner side of the semi-ring structure and an arc-shaped side wall of the barrier layer jointly enclose one second hollow-out region.

In a possible implementation, the first metal layer and at least one adjacent second metal layer are connected and form an integrated structure. In this way, a manufacturing procedure of the substrate may be simplified, and a manufacturing cost of the substrate may be reduced.

In a possible implementation, the first metal layer and two adjacent second metal layers are connected and form an integrated structure. In this way, a manufacturing procedure of the substrate may be simplified, and a manufacturing cost of the substrate may be reduced.

In a possible implementation, the array is in a square shape, the first metal layer is disposed near a second metal layer that is on an outermost side of the array and that is located at a corner, and the first metal layer and three adjacent second metal layers are connected and form an integrated structure. In this way, a manufacturing procedure of the substrate may be simplified, and a manufacturing cost of the substrate may be reduced. In addition, soldering areas at the four corners of the array may be increased to improve solder joint reliability.

In a possible implementation, one first metal layer is disposed on one side of each second metal layer on an outermost side of the array, and the first metal layer is located on one side that is of the second metal layer on the outermost side and that faces outward. A design is performed for a single second metal layer, so that an application working condition scenario of the substrate may be expanded.

In a possible implementation, the array is in a square shape, and an exposed area of a first metal layer that is located on the outermost side of the array and that is located at a corner is greater than an exposed area of a first metal layer at another position. For the second metal layers arranged in the square array, a cracking risk of a solder joint at a corner is greater than a cracking risk of a solder joint on an edge. The exposed area of the first metal layer located at the corner is set to be greater than the exposed area of the first metal layer at the another position, so that solder joint reliability may be further improved after the substrate is connected to the circuit board.

In a possible implementation, a thickness of an annular wall of the barrier ring is between 0.05 mm (2 mils) and 0.20 mm (8 mils).

In a possible implementation, all the second hollow-out regions have a same shape and an equal area. In this way, after the prefabricated solder balls are attached to the second hollow-out regions and soldered to the second metal layers through reflow soldering, it may be ensured that the shapes of the solder balls are the same, and the purpose of same coplanarity of the solder balls may be achieved.

Another aspect of embodiments of this application provides a packaging structure of claim 9, including at least one electronic component, a protective cover, and the substrate described above. The substrate has an attachment region, the electronic component is fastened to the attachment region, the electronic component is electrically connected to the substrate, and the protective cover covers the substrate to protect the electronic component.

In the packaging structure provided in this embodiment of this application, in a process in which the substrate is soldered to a circuit board after balls (solder balls) are placed, because the first hollow-out region is disposed near the second hollow-out region, the barrier layer between the first hollow-out region and the second hollow-out region is relatively narrow, and the solder balls collapse under pressure of the substrate due to a weight. In addition, a specific amount of solder is printed on the circuit board, and the solder may easily cross the barrier layer and be spread onto the first metal layer, thereby forming a larger soldering area to improve solder joint reliability. In addition, because the substrate provided in this embodiment of this application may implement the larger soldering area, the second hollow-out regions electrically connected to the solder balls may be disposed as regions with an equal hollow-out area. The second hollow-out regions are separated from each other and are separated from the first hollow-out region. After the prefabricated solder balls are attached to the second hollow-out regions and soldered to the second metal layers through reflow soldering, it may be ensured that shapes of the solder balls are the same, and a purpose of same coplanarity of the solder balls may be achieved. Moreover, when the substrate provided in this embodiment of this application is manufactured, opening shapes of the first hollow-out region and the second hollow-out region may be preset, and machining of the barrier layer is completed by using a conventional solder mask layer machining process, thereby avoiding addition of an additional procedure and an increase in management and control difficulty.

Still another aspect of embodiments of this application provides an electronic device, including a circuit board and the packaging structure described above. The packaging structure is electrically connected to the circuit board.

In the electronic device provided in this embodiment of this application, in a process in which the substrate is soldered to the circuit board after balls (solder balls) are placed, because the first hollow-out region is disposed near the second hollow-out region, the barrier layer between the first hollow-out region and the second hollow-out region is relatively narrow, and the solder balls collapse under pressure of the substrate due to a weight. In addition, a specific amount of solder is printed on the circuit board, and the solder may easily cross the barrier layer and be spread onto the first metal layer, thereby forming a larger soldering area to improve solder joint reliability. In addition, because the substrate provided in this embodiment of this application may implement the larger soldering area, the second hollow-out regions electrically connected to the solder balls may be disposed as regions with an equal hollow-out area. The second hollow-out regions are separated from each other and are separated from the first hollow-out region. After the prefabricated solder balls are attached to the second hollow-out regions and soldered to the second metal layers through reflow soldering, it may be ensured that shapes of the solder balls are the same, and a purpose of same coplanarity of the solder balls may be achieved. Moreover, when the substrate provided in this embodiment of this application is manufactured, opening shapes of the first hollow-out region and the second hollow-out region may be preset, and machining of the barrier layer is completed by using a conventional solder mask layer machining process, thereby avoiding addition of an additional procedure and an increase in management and control difficulty.

### BRIEF DESCRIPTION OF DRAWINGS

FIG. 1 is a diagram of a structure of a ball grid array packaged chip in a related technology;
FIG. 2 is a diagram of a structure of a board-level architecture in a related technology;
FIG. 3 is a distribution diagram of high-risk regions for solder joint reliability of a ball grid array packaged chip;
FIG. 4 is a diagram of using adjacent pads with a same attribute to increase a soldering area of a ball grid array packaged chip;
FIG. 5 is a diagram of increasing a soldering area of a ball grid array packaged chip in a related technology;
FIG. 6 is a defect description diagram of the technology shown in FIG. 5;
FIG. 7 is a diagram of a structure of a substrate according to an embodiment of this application;
FIG. 8 is a diagram of a cross-section structure along an A-A cut line in FIG. 7;
FIG. 9 is a diagram of an enlarged structure of a region B in FIG. 7;
FIG. 10 is a diagram of a cross-section structure along a C-C cut line in FIG. 9;
FIG. 11 is a diagram of step 1 of soldering a substrate to a circuit board according to an embodiment of this application;
FIG. 12 is a diagram of step 2 of soldering a substrate to a circuit board according to an embodiment of this application;
FIG. 13 is a diagram of step 3 of soldering a substrate to a circuit board according to an embodiment of this application;
FIG. 14 is a diagram of step 4 of soldering a substrate to a circuit board according to an embodiment of this application;
FIG. 15 is a diagram of a partial structure of a substrate according to an embodiment of this application;
FIG. 16 is a diagram of a structure of a substrate according to an embodiment of this application;
FIG. 17 is a diagram of a first hollow-out region, a second hollow-out region, and a barrier layer at a corner of an array in FIG. 16;
FIG. 18 is a diagram of a first hollow-out region, a second hollow-out region, and a barrier layer on an edge of an array in FIG. 16;
FIG. 19 is a diagram of step 1 of soldering a substrate to a circuit board according to an embodiment of this application;
FIG. 20 is a diagram of step 2 of soldering a substrate to a circuit board according to an embodiment of this application;
FIG. 21 is a diagram of step 3 of soldering a substrate to a circuit board according to an embodiment of this application;
FIG. 22 is a diagram of step 4 of soldering a substrate to a circuit board according to an embodiment of this application;
FIG. 23 is a diagram of a structure of a substrate according to an embodiment of this application;
FIG. 24 is design forms of a first hollow-out region, a second hollow-out region, and a barrier ring according to this application; and
FIG. 25 is a diagram of a packaging structure according to an embodiment of this application.

Reference numerals:
1: ball grid array packaged chip;
11: bare chip; 12: substrate; 13: protective cover;
14: solder ball; 15: metal chassis; 2: board-level architecture;
21: circuit board; 3: conductive sheet; 4: metal sheet;
5: solder mask layer; 6: solder paste;
100: substrate;
110: base body; 120: barrier layer; 121: first hollow-out region;
122: second hollow-out region; 123: barrier ring; 130: first metal layer;
140: second metal layer;
200: packaging structure; and
210: electronic component; 220: protective cover.

### DESCRIPTION OF EMBODIMENTS

Terms used in embodiments of this application are only used to explain specific embodiments of this application, but are not intended to limit this application.

A circuit board is a provider of electrical connections for electronic components. A chip is a core part of an electronic device, and has functions of logic processing and controlling normal running of the entire device. In the electronic device, a bare chip and a substrate form a packaging structure. The packaging structure is fastened to a printed circuit board (PCB) to form a board-level architecture. The board-level architecture may control conduction between the bare chip in the packaging structure and an external circuit board.

As electronic products become increasingly intelligent in functions and increasingly miniaturized in sizes, chips in electronic products become increasingly complex, and an I/O quantity is increasingly large. A packaging format of a flip chip ball grid array (FC-BGA) has become a commonly used packaging form in high-end devices and the field of high-density packaging, and a ball grid array (BGA) packaged chip has also become a mainstream of packaged components. The FC-BGA is a high-density semiconductor packaging form that can realize a high-speed and multifunction chip of a large-scale integrated circuit (LSI).

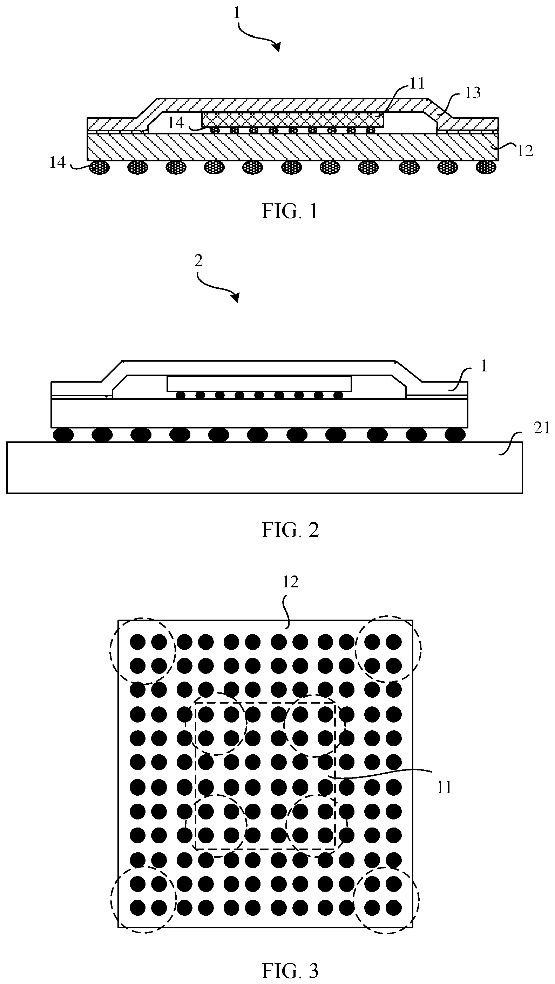

FIG. 1 is a diagram of a structure of a ball grid array packaged chip 1 in a related technology. Refer to FIG. 1. The ball grid array packaged chip 1 includes a bare chip 11, a substrate 12, and a protective cover 13. The bare chip 11 is fastened to an upper surface of the substrate 12 by using solder balls 14 arranged in a matrix array, the protective cover 13 covers the upper surface of the substrate 12 to protect the bare chip 11, and solder balls 14 arranged in a matrix array are also disposed on a lower surface of the substrate 12 for soldering with a PCB. As an important component material of chip packaging, the substrate 12 mainly bears and protects the bare chip 11 and connects the upper-layer bare chip 11 to the lower-layer PCB.

FIG. 2 is a diagram of a structure of a board-level architecture 2 in a related technology. Refer to FIG. 2. With reference to FIG. 1, the board-level architecture 2 includes the ball grid array packaged chip 1 shown in FIG. 1 and a circuit board 21. The ball grid array packaged chip 1 is fastened to the circuit board 21 by using the solder balls 14 arranged in a matrix array on the lower surface of the substrate 12, to implement an electrical connection between the ball grid array packaged chip 1 and the circuit board 21.

It should be noted that both the substrate 12 and the circuit board 21 include conventional components such as a via, a solder mask layer, and a copper wire. To simplify the diagram, these parts are omitted.

Due to factors such as mechanical vibration and a temperature difference between working and non-working states of the chip, the ball grid array packaged chip 1 has a risk of fatigue cracking of a solder joint. A form of the risk is that a solder ball cracks, especially in a boundary region of the solder balls 14 arranged in a matrix array. High-risk regions for solder joint reliability of the ball grid array packaged chip 1 are generally concentrated at four corners at which the substrate 12 is connected to the circuit board 21 and four corners at which the bare chip 11 is connected to the substrate 12. For the high-risk regions for solder joint reliability, refer to positions circled by dashed lines in FIG. 3 (FIG. 3 is a distribution diagram of high-risk regions for solder joint reliability of a ball grid array packaged chip).

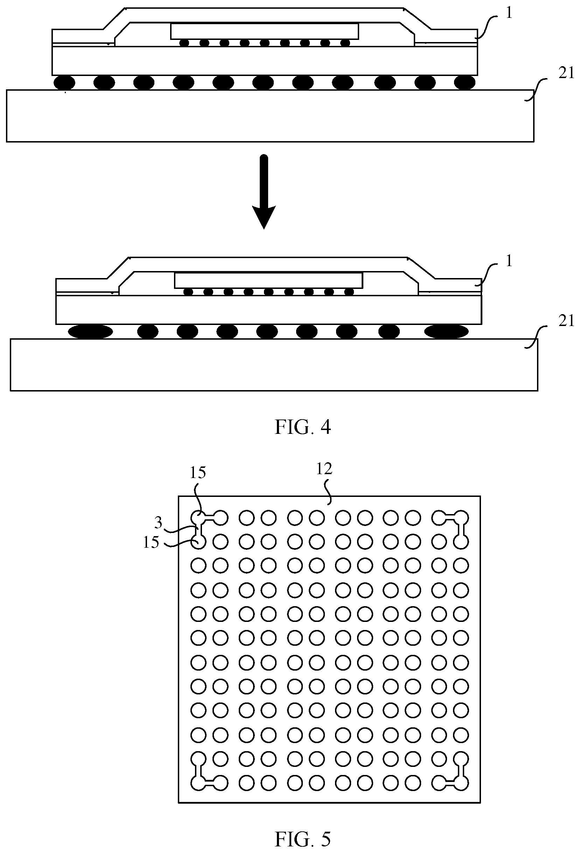

It is easy to understand that, to effectively improve a reliability capability of a solder joint, a soldering area of the solder joint may be increased. For example, adjacent pads with a same attribute at a corner of the ball grid array packaged chip 1 are used to increase the soldering area. For example, as shown in FIG. 4, FIG. 4 is a diagram of using adjacent pads with a same attribute to increase a soldering area of a ball grid array packaged chip 1. If the adjacent pads are all grounding network pads, non-functional pads, or the like, the adjacent pads with the same attribute may be used to increase the soldering area by using a larger solder ball.

How to increase a soldering area by performing a specific operation has also become a problem that needs to be resolved in the industry. The following describes three related technologies for increasing the soldering area.

FIG. 5 is a diagram of increasing a soldering area of a ball grid array packaged chip in a related technology. Refer to FIG. 5. A method is as follows: A conductive sheet 3 is disposed between metal chassis 15 of adjacent pads with a same attribute on a substrate 12 to connect two or more metal chassis 15, and solder is wetted and diffused to the conductive sheet 3 in a soldering process, thereby increasing the soldering area.

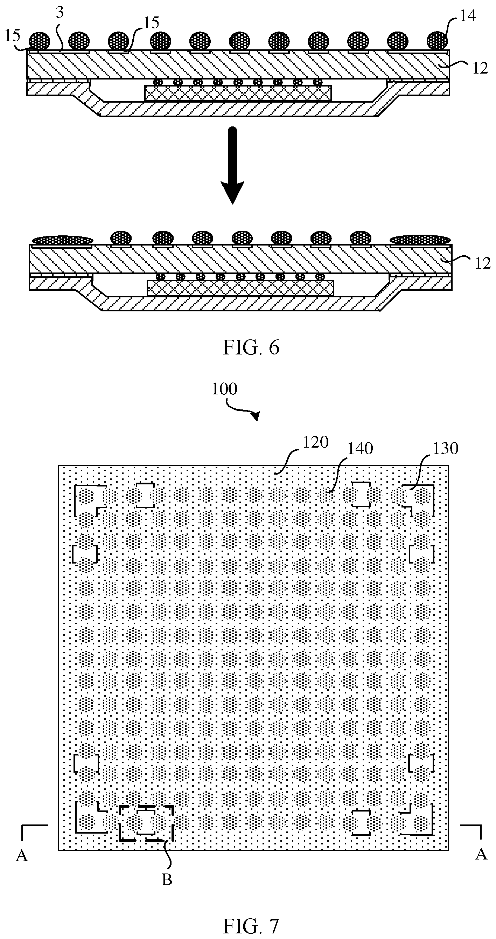

However, the method has a defect. FIG. 6 is a defect description diagram of the technology shown in FIG. 5. Refer to FIG. 6. In FIG. 6, a first diagram is a diagram after solder balls 14 are attached to the substrate 12, and a second diagram is a diagram after the solder balls 14 experience reflow soldering. It may be learned from FIG. 6 that, because the conductive sheet 3 is added between the metal chassis 15 of the adjacent pads with the same attribute, it may be considered that an area of the metal chassis 15 is increased. After the solder balls 14 are melted through reflow soldering, due to an increase in the area of the metal chassis 15 and an effect of liquid surface tension, a solder ball 14 on the metal chassis 15 whose area is increased collapses to a greater degree than a solder ball 14 on a conventional metal chassis 15. Therefore, a height of the solder ball 14 on the metal chassis 15 whose area is increased is lower than a height of the solder ball 14 on the conventional metal chassis 15, and it is difficult to control coplanarity of the solder balls 14. This may cause a problem of poor soldering, and may also affect identification of a device because shapes of the solder balls 14 are irregular. In addition, in the method, an additional operation is added to a packaging factory, and machining difficulty is increased, thereby causing a chip cost to increase.

A second method is as follows: A metal chassis in a high-risk region for solder joint reliability on the substrate 12 is enlarged, and two or more solder balls are attached to the metal chassis. In this way, after reflow soldering, the plurality of solder balls may be re-melted and solidified into a large solder ball, thereby increasing a soldering area. However, the method has a same problem as the method shown in FIG. 5. That is, after the solder balls are melted through reflow soldering, due to an increase in an area of the metal chassis and an effect of liquid surface tension, a solder ball on the metal chassis whose area is increased collapses to a greater degree than a solder ball on a conventional metal chassis. Therefore, a height of the solder ball on the metal chassis whose area is increased is lower than a height of the solder ball on the conventional metal chassis, and it is difficult to control coplanarity of the solder balls. This may cause a problem of poor soldering, and may also affect identification of a device because shapes of the solder balls are irregular.

A third method is to enlarge a pad on a side of a circuit board 21. However, in the method, only an area of the pad on the single side of the circuit board 21 is increased, but a soldering area of a pad on a chip side is not increased. In this way, stress concentration is formed, and overall solder joint reliability is not improved, but the reliability may be deteriorated.

To resolve the foregoing problem, embodiments of this application provide a substrate, a packaging structure, and an electronic device. A structure of the substrate may resolve a problem of an additional operation of a packaging factory in a ball placement phase of packaging and a problem of difficulty in controlling coplanarity of solder balls, so that there is no impact on the packaging factory. In addition, by using a characteristic that solder bridging easily occurs on adjacent conductors in a case of a fine spacing and a large amount of solder, soldering with a large pad is formed when a ball grid array packaged chip is assembled with a circuit board, so that solder joint reliability of this type of chip is improved at a low cost.

With reference to accompanying drawings and specific embodiments, the following describes in detail the substrate, the packaging structure, and the electronic device that are provided in embodiments of this application.

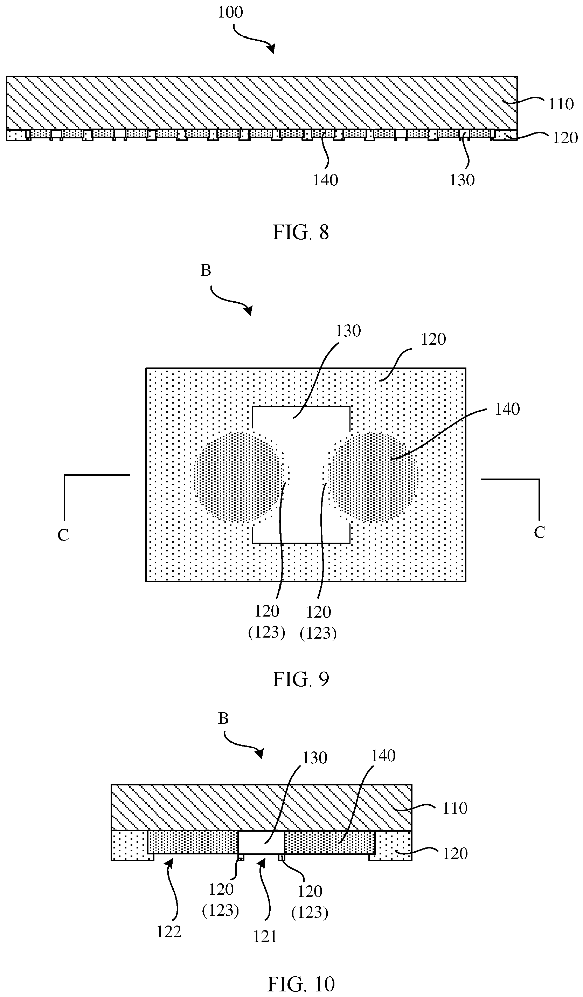

FIG. 7 is a diagram of a structure of a substrate 100 according to an embodiment of this application. FIG. 8 is a diagram of a cross-section structure along an A-A cut line in FIG. 7. Refer to FIG. 7 and FIG. 8. The substrate 100 provided in this embodiment of this application includes a base body 110 and a barrier layer 120 disposed on a surface of the base body 110. A first metal layer 130 and a plurality of second metal layers 140 arranged in an array are disposed between the base body 110 and the barrier layer 120.

It should be noted that, in this application, arrangement regions of the barrier layer 120 disposed on the surface of the base body 110, and the first metal layer 130 and the plurality of second metal layers 140 arranged in an array that are disposed between the base body 110 and the barrier layer 120 may be on a surface that is of the substrate 100 and that is connected to a circuit board, or may be a bare chip assembly region on a surface that is of the substrate 100 and that is connected to a bare chip. In the accompanying drawing of this application, an example in which the barrier layer 120, the first metal layer 130, and the second metal layers 140 are disposed on the surface that is of the substrate 100 and that is connected to the circuit board is used for description.

It should be further noted that, in this application, the plurality of second metal layers 140 arranged in an array may be arranged in a matrix array, or may be arranged in an array of any shape, for example, arranged in a circular array or a triangular array. In this application, an example in which the plurality of second metal layers 140 are arranged in a matrix array is used for description. In this application, different filling diagrams of various components are merely used to distinguish between the components, and do not indicate that different components cannot use a same material, and do not indicate that a same component may use a same material. In this application, all the accompanying drawings are not drawn based on actual scales of the parts. Therefore, this application should not be limited to scales, sizes, and the like shown in the accompanying drawings.

To describe the substrate 100 provided in this embodiment of this application more clearly based on the accompanying drawing, a region B in FIG. 7 is extracted and enlarged, and the region B is described. This does not affect interpretation of the substrate 100 provided in this embodiment of this application.

FIG. 9 is a diagram of an enlarged structure of a region B in FIG. 7. FIG. 10 is a diagram of a cross-section structure along a C-C cut line in FIG. 9. Refer to FIG. 9 and FIG. 10. With reference to FIG. 7 and FIG. 8, the substrate 100 provided in this embodiment of this application includes the base body 110 and the barrier layer 120 disposed on the surface of the base body 110. The barrier layer 120 may be a conventional solder mask layer in a related technology, and a material and a model of the solder mask layer are not limited. The first metal layer 130 and the plurality of second metal layers 140 arranged in an array are disposed between the base body 110 and the barrier layer 120.

The first metal layer 130 is disposed near at least a part of the second metal layers 140 on an outer side of the array. For example, as shown in FIG. 7, first metal layers 130 are disposed near second metal layers that are on outermost sides of the array and that are located at four corners. This is because a high-risk region for solder joint cracking generally appears at the four corners. Certainly, in some other embodiments, the first metal layer 130 may be disposed near all second metal layers 140 on the outer side of the array.

It should be noted that, in "the first metal layer 130 is disposed near at least a part of the second metal layers 140 on an outer side of the array", "outer side" does not merely refer to one outermost row or column in the array, and may also be two rows (columns), three rows (columns), or more.

Still refer to FIG. 7 to FIG. 10. With particular attention to FIG. 10, a first hollow-out region 121 is provided at a position that is of the barrier layer 120 and that is opposite to the first metal layer 130, and at least a part of the first metal layer 130 is exposed in the first hollow-out region 121. That "at least a part of the first metal layer 130 is exposed in the first hollow-out region 121" means that the first metal layer 130 may be completely exposed in the first hollow-out region 121, or a part of the first metal layer 130 may be exposed in the first hollow-out region 121. In FIG. 10, an example in which a part of the first metal layer 130 is exposed in the first hollow-out region 121 is used for description.

A second hollow-out region 122 is provided at a position that is of the barrier layer 120 and that is opposite to each second metal layer 140, at least a part of the second metal layer 140 is exposed in the second hollow-out region 122, and the second hollow-out regions 122 are separated from each other. The second hollow-out region 122 is used for attaching a prefabricated solder part (for example, a solder ball), and the solder part is soldered to the second metal layer 140 through reflow soldering. That "at least a part of the second metal layer 140 is exposed in the second hollow-out region 122" means that the second metal layer 140 may be completely exposed in the second hollow-out region 122, or a part of the second metal layer 140 may be exposed in the second hollow-out region 122. In FIG. 10, an example in which a part of the second metal layer 140 is exposed in the second hollow-out region 122 is used for description.

The first hollow-out region 121 is separated from the second hollow-out region 122. Refer to FIG. 10. The first hollow-out region 121 is separated from the second hollow-out region 122 by the barrier layer 120.

The following describes steps of soldering the substrate 100 to a circuit board 21, and also uses a part of the substrate 100 shown in the region B in FIG. 7 as an example for description.

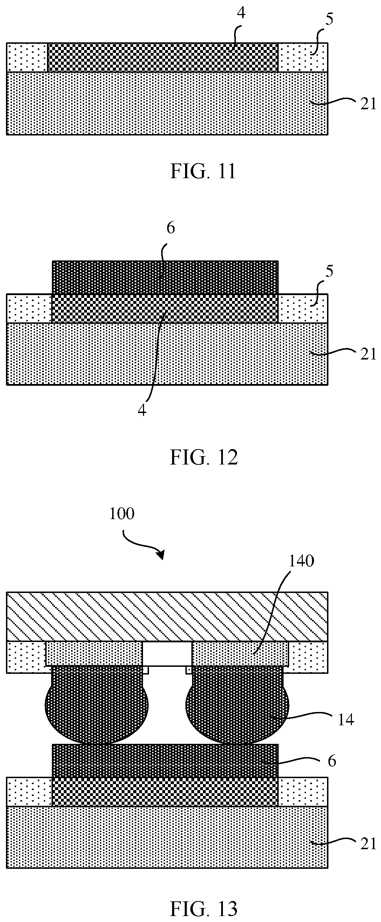

Step 1: FIG. 11 is a diagram of step 1 of soldering the substrate 100 to the circuit board according to an embodiment of this application. Refer to FIG. 11. A metal sheet 4 is designed at a position that is of the circuit board 21 and that corresponds to the region B of the substrate 100, and the metal sheet 4 is surrounded by a solder mask layer 5.

Step 2: FIG. 12 is a diagram of step 2 of soldering the substrate 100 to the circuit board according to an embodiment of this application. Refer to FIG. 12. A proper stencil opening is designed, and a sufficient amount of solder paste 6 is printed on the metal sheet 4. As an explanation, a stencil is a dedicated mold in a surface mount technology, and a main function is to help deposit the solder paste 6, to transfer an accurate amount of solder paste 6 to an accurate position on the circuit board 21.

Step 3: FIG. 13 is a diagram of step 3 of soldering the substrate 100 to the circuit board according to an embodiment of this application. Refer to FIG. 13. After a prefabricated solder ball 14 is attached to the second hollow-out region 122 and soldered to the second metal layer 140 through reflow soldering, the solder ball 14 on the substrate 100 is attached to the solder paste 6 on the circuit board 21.

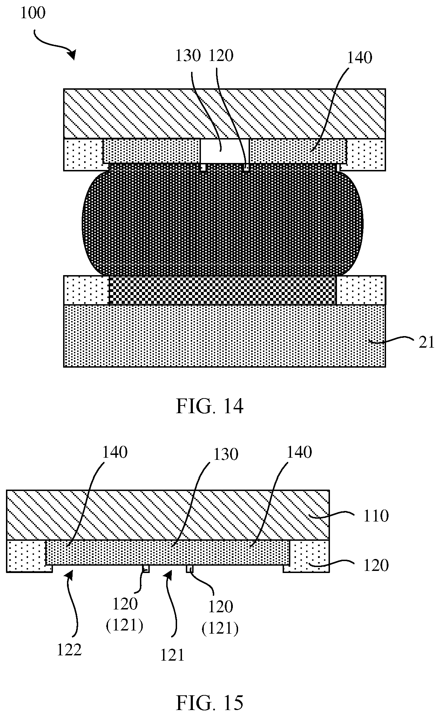

Step 4: FIG. 14 is a diagram of step 4 of soldering the substrate 100 to the circuit board according to an embodiment of this application. Refer to FIG. 14. After being heated by using a reflow oven, the solder ball 14 on the substrate 100 and the solder paste 6 are melted into a whole. Because there is a sufficient amount of solder paste 6, and the substrate 100 presses the solder paste 6 due to a weight in a soldering process, the solder paste 6 crosses the barrier layer 120 and is evenly spread onto the first metal layer 130 after being squeezed, thereby achieving an effect of increasing a soldering area.

It may be understood that, in the substrate 100 provided in this embodiment of this application, in a process in which the substrate 100 is soldered to the circuit board after balls (solder balls) are placed, because the first hollow-out region 121 is disposed near the second hollow-out region 122, the barrier layer 120 between the first hollow-out region 121 and the second hollow-out region 122 is relatively narrow, and the solder balls collapse under pressure of the substrate 100 due to a weight. In addition, a specific amount of solder is printed on the circuit board, and the solder may easily cross the barrier layer 120 and be spread onto the first metal layer 130, thereby forming a larger soldering area to improve solder joint reliability. In addition, because the substrate 100 provided in this embodiment of this application may implement the larger soldering area, the second hollow-out regions 122 electrically connected to the solder balls may be disposed as regions with an equal hollow-out area. The second hollow-out regions 122 are separated from each other and are separated from the first hollow-out region 121. After the prefabricated solder balls are attached to the second hollow-out regions 122 and soldered to the second metal layers 140 through reflow soldering, it may be ensured that shapes of the solder balls are the same, and a purpose of same coplanarity of the solder balls may be achieved. Moreover, when the substrate 100 provided in this embodiment of this application is manufactured, opening shapes of the first hollow-out region 121 and the second hollow-out region 122 may be preset, and machining of the barrier layer is completed by using a conventional solder mask layer machining process, thereby avoiding addition of an additional procedure and an increase in management and control difficulty.

In some embodiments of this application, all the second hollow-out regions 122 have a same shape and an equal area. In this way, after the prefabricated solder balls are attached to the second hollow-out regions 122 and soldered to the second metal layers 140 through reflow soldering, it may be ensured that the shapes of the solder balls are the same, and the purpose of same coplanarity of the solder balls may be achieved.

It should be noted that FIG. 15 is a diagram of a partial structure of a substrate 100 according to an embodiment of this application. Refer to FIG. 15. In comparison with FIG. 10, in some embodiments of this application, the first metal layer 130 and at least one adjacent second metal layer 140 are connected and form an integrated structure, and the first metal layer 130 and the second metal layer 140 may be made of a same material or different materials.

For example, as shown in FIG. 15, the first metal layer 130 and two adjacent second metal layers 140 are connected and form an integrated structure, and the first metal layer 130 and the second metal layers 140 are made of a same material. In this way, a manufacturing procedure of the substrate 100 may be simplified, and a manufacturing cost of the substrate 100 may be reduced.

For another example, as shown in FIG. 7, in some embodiments of this application, the array is in a square shape, the first metal layer 130 is disposed near a second metal layer 140 that is on an outermost side of the array and that is located at a corner, and the first metal layer 130 and three adjacent second metal layers 140 are connected and form an integrated structure. In this way, a manufacturing procedure of the substrate 100 may be simplified, and a manufacturing cost of the substrate 100 may be reduced. In addition, soldering areas at the four corners of the array may be increased to improve solder joint reliability.

Based on the foregoing description, it may be understood that, at a position at which a soldering area is increased, one or more first metal layers 130 and a plurality of second metal layers 140 that are arranged in a linear shape may be combined, or a plurality of first metal layers 130 and a plurality of second metal layers 140 that are arranged in any shape may be combined. This is not limited herein.

Still refer to FIG. 7, FIG. 9, and FIG. 10. In some embodiments of this application, the barrier layer 120 has at least one barrier ring 123, the barrier ring 123 is located between the first hollow-out region 121 and the second hollow-out region 122, and the first hollow-out region 121 is separated from the adjacent second hollow-out region 122 by the barrier ring 123. It may be understood that the barrier ring 123 with a regular form and a same width is disposed between the first hollow-out region 121 and the adjacent second hollow-out region 122. In comparison with a barrier material with an irregular form disposed between the first hollow-out region 121 and the adjacent second hollow-out region 122, in a process of soldering the substrate 100 to the circuit board, solder may more easily and evenly cross the barrier material between the first hollow-out region 121 and the second hollow-out region 122 and be spread onto the first metal layer 130, thereby more effectively increasing a soldering area to improve solder joint reliability.

In some embodiments of this application, a thickness of an annular wall of the barrier ring 123 (that is, a difference between an outer diameter and an inner diameter of the barrier ring 123) may be set to be between 0.05 mm (2 mils) and 0.20 mm (8 mils). For example, the thickness of the annular wall may be 0.05 mm (2 mils) 0.13 mm (5 mils) or 0.20 mm (8 mils). As a supplementary explanation, mil is a unit of length, representing one thousandth of an inch.

With regard to a definition of a shape of the barrier ring 123, the barrier ring 123 may be a sector ring shape , as shown in FIG. 9 and FIG. 10. The barrier ring 123 is a semi-ring structure, and an inner side of the semi-ring structure and an arc-shaped side wall of the barrier layer 120 jointly enclose one second hollow-out region 122. For example, as shown in FIG. 7, an outermost corner of a square array is used as an example. The barrier ring 123 may be a 360° annular structure, and an inner side of the annular structure encloses one second hollow-out region 122 adjacent to the first hollow-out region 121. It may be understood that the barrier ring 123 of the annular structure encloses one second hollow-out region 122, and the second hollow-out region 122 is separated from the first hollow-out region 121 by the barrier ring 123 of the annular structure.

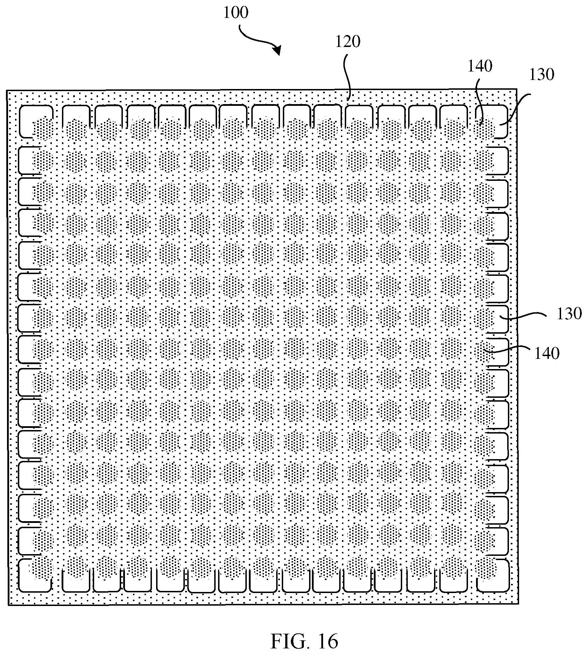

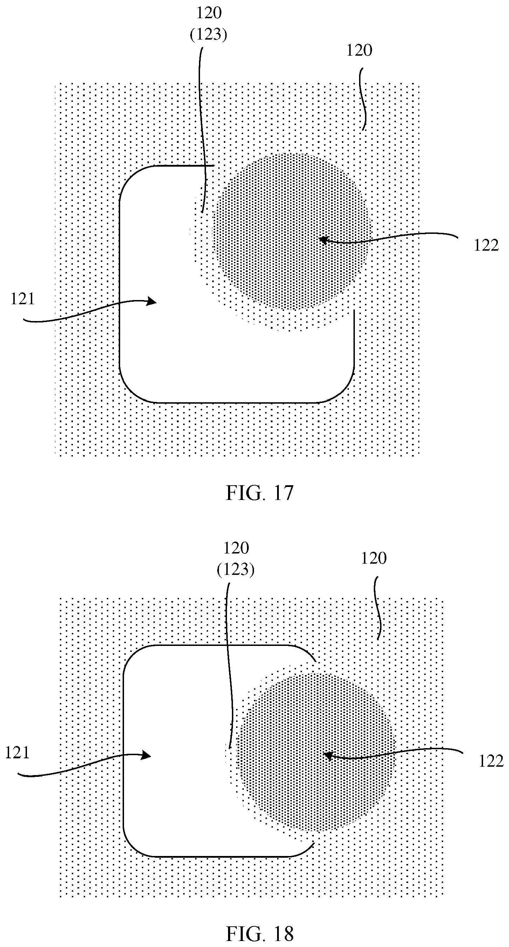

Certainly, this application is not limited thereto. FIG. 16 is a diagram of a structure of a substrate 100 according to an embodiment of this application. FIG. 17 is a diagram of a first hollow-out region 121, a second hollow-out region 122, and a barrier layer 120 at a corner of an array in FIG. 16. FIG. 18 is a diagram of a first hollow-out region 121, a second hollow-out region 122, and a barrier layer 120 on an edge of an array in FIG. 16. Refer to FIG. 16 to FIG. 18. In some embodiments of this application, one first metal layer 130 is disposed on one side of each second metal layer 140 on an outermost side of the array, and the first metal layer 130 is located on one side that is of the second metal layer 140 on the outermost side and that faces outward. It may be understood that, herein, that the first metal layer 130 is located on one side that is of the second metal layer 140 on the outermost side and that faces outward is determined based on a high-density arrangement feature of the second metal layers 140. The first metal layer 130 is located on one side that is of the second metal layer 140 on the outermost side and that faces outward, so that interference with a second metal layer 140 in the array may be avoided. Certainly, it may be understood that the first metal layer 130 does not necessarily need to be disposed on one side that is of the second metal layer 140 on the outermost side and that faces outward, and may be disposed based on an actual working condition.

Based on the principle described above, refer to FIG. 17 and FIG. 18. A second hollow-out region 122 corresponding to each second metal layer 140 located on the outermost side of the array is separated from a first hollow-out region 121 corresponding to each first metal layer 130 by the barrier layer 120 or the barrier ring 123. In a process in which the substrate 100 is soldered to the circuit board after balls (solder balls) are placed, because the first hollow-out region 121 is disposed near the second hollow-out region 122, the barrier layer 120 between the first hollow-out region 121 and the second hollow-out region 122 is relatively narrow, and the solder balls collapse under pressure of the substrate 100 due to a weight. In addition, a specific amount of solder is printed on the circuit board, and the solder may easily cross the barrier layer 120 and be spread onto the first metal layer 130, thereby forming a larger soldering area to improve solder joint reliability. In addition, because the substrate 100 provided in this embodiment of this application may implement the larger soldering area, the second hollow-out regions 122 electrically connected to the solder balls may be disposed as regions with an equal hollow-out area. The second hollow-out regions 122 are separated from each other and are separated from the first hollow-out region 121. After the prefabricated solder balls are attached to the second hollow-out regions 122 and soldered to the second metal layers 140 through reflow soldering, it may be ensured that shapes of the solder balls are the same, and a purpose of same coplanarity of the solder balls may be achieved. Moreover, when the substrate 100 provided in this embodiment of this application is manufactured, opening shapes of the first hollow-out region 121 and the second hollow-out region 122 may be preset, and machining of the barrier layer is completed by using a conventional solder mask layer machining process, thereby avoiding addition of an additional procedure and an increase in management and control difficulty.

Still refer to FIG. 16 to FIG. 18. In some embodiments of this application, the second metal layers 140 are arranged in a square array, and an exposed area of a first metal layer 130 that is located on the outermost side of the array and that is located at a corner is greater than an exposed area of a first metal layer 130 at another position.

It should be understood that, for the second metal layers 140 arranged in the square array, a cracking risk of a solder joint at a corner is greater than a cracking risk of a solder joint on an edge. The exposed area of the first metal layer 130 located at the corner is set to be greater than the exposed area of the first metal layer 130 at the another position, so that solder joint reliability may be further improved after the substrate 100 is connected to the circuit board.

Steps of soldering the substrate 100 shown in FIG. 16 to the circuit board are the same as the steps of soldering the substrate 100 shown in FIG. 7. The following describes the steps of soldering the substrate 100 shown in FIG. 16 to the circuit board, and uses two characteristic second metal layers 140 captured from the outermost side as an example for description.

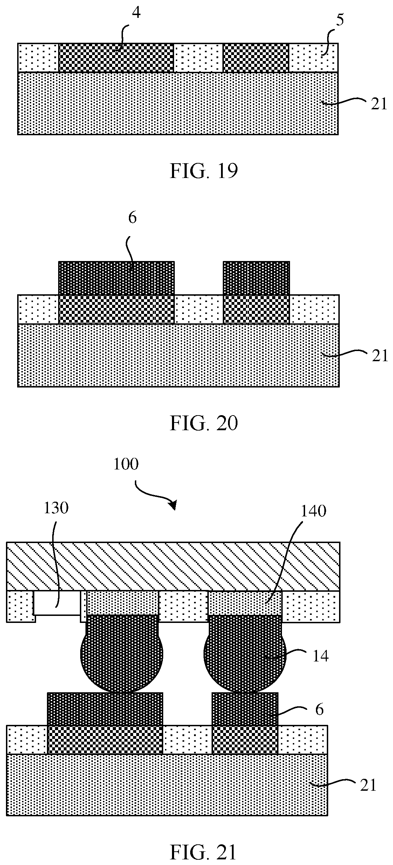

Step 1: FIG. 19 is a diagram of step 1 of soldering the substrate 100 to the circuit board according to an embodiment of this application. Refer to FIG. 19. A metal sheet 4 is designed at a position that is of the circuit board 21 and that corresponds to a first hollow-out region 121 and a second hollow-out region 122, a metal sheet 4 is disposed at a position that is of the circuit board 21 and that corresponds to a conventional second hollow-out region 122, and the metal sheets 4 are surrounded by a solder mask layer 5.

Step 2: FIG. 20 is a diagram of step 2 of soldering the substrate 100 to the circuit board according to an embodiment of this application. Refer to FIG. 20. A proper stencil opening is designed, and a sufficient amount of solder paste 6 is printed on the metal sheets 4.

Step 3: FIG. 21 is a diagram of step 3 of soldering the substrate 100 to the circuit board according to an embodiment of this application. Refer to FIG. 21. After a prefabricated solder ball 14 is attached to the second hollow-out region 122 and soldered to the second metal layer 140 through reflow soldering, the solder ball 14 on the substrate 100 is attached to the solder paste 6 on the circuit board 21.

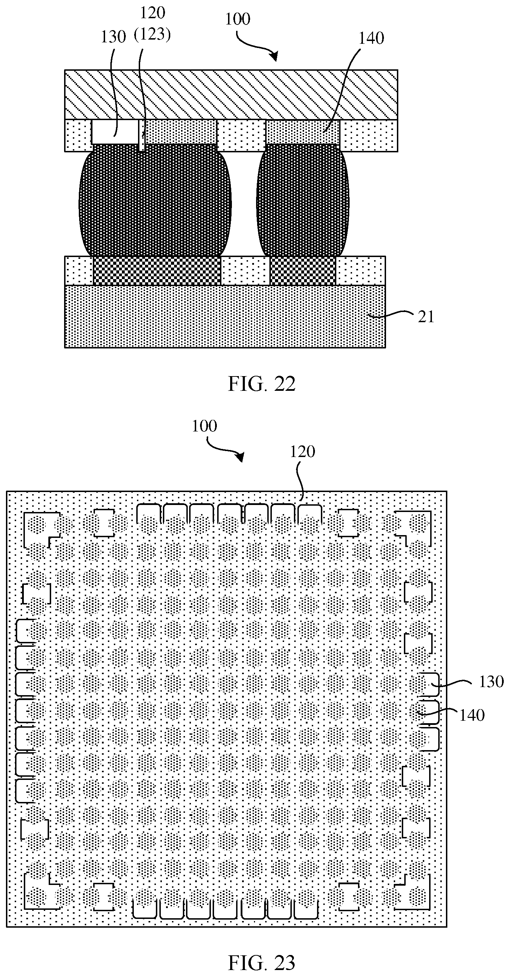

Step 4: FIG. 22 is a diagram of step 4 of soldering the substrate 100 to the circuit board according to an embodiment of this application. Refer to FIG. 22. After being heated by using a reflow oven, the solder ball 14 on the substrate 100 and the solder paste 6 are melted into a whole. Because there is a sufficient amount of solder paste 6, and the substrate 100 presses the solder paste 6 due to a weight in a soldering process, the solder paste 6 crosses the barrier layer 120 and is evenly spread onto the first metal layer 130 after being squeezed, thereby achieving an effect of increasing a soldering area.

It may be understood that a manner of increasing the soldering area in FIG. 7 is that one or more first metal layers 130 are connected to a plurality of second metal layers 140, and a manner of increasing the soldering area in FIG. 16 is that one first metal layer 130 is connected to one second metal layer 140. As an expansion, in some embodiments of this application, the manner of increasing the soldering area in FIG. 7 may be flexibly combined with the manner of increasing the soldering area in FIG. 16. For example, FIG. 23 is a diagram of a structure of a substrate 100 according to an embodiment of this application. Refer to FIG. 23. In some embodiments of this application, the manner in which one or more first metal layers 130 are connected to a plurality of second metal layers 140 is used at the four corners of the array, and the manner in which one first metal layer 130 is connected to one second metal layer 140 is used on an edge of the array. Certainly, flexible combination manners include but are not limited to the foregoing example, and are not exhaustively listed herein.

It should be noted that shapes of the first hollow-out region 121 and the second hollow-out region 122 on the substrate 100 may be circles, squares, or any shapes. In the foregoing accompanying drawings of this application, that the second hollow-out region 122 is a conventional circle is used for description. The following describes several design forms of the first hollow-out region 121, the second hollow-out region 122, and the barrier ring 123. It should be understood that the following design forms are merely used as typical references, and do not represent all designs.

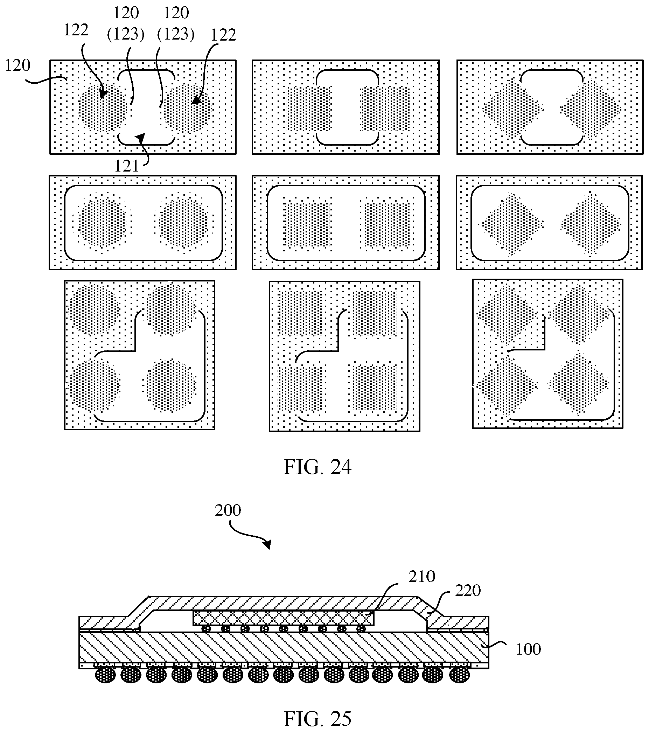

FIG. 24 is design forms of a first hollow-out region 121, a second hollow-out region 122, and a barrier ring 123 according to this application. Refer to FIG. 24. Two, three, or four adjacent second metal layers 140 are used as a typical design. In FIG. 24, the second hollow-out region 122 may be a circle, a square, or a rhombus, the barrier ring 123 varies according to a variation of the second hollow-out region 122, and a shape of the first hollow-out region 121 may not be limited.

The substrate 100 provided in this embodiment of this application may be applied to a scenario requiring high reliability of a solder joint, for example, a ball grid array packaged chip in a scenario such as energy saving and emission reduction, or an in-vehicle scenario.

In conclusion, according to the substrate 100 provided in this embodiment of this application, the barrier ring 123 with a proper width 0.05 mm (2 mils) to 0.2 mm (8 mils) of the annular wall is designed by cleverly using a solder mask function of the barrier ring 123 and a characteristic that solder bridging occurs during soldering in a case of a large amount of solder, so that it can be ensured that placement of solder balls in a packaging factory is not affected, and when a chip is soldered to a circuit board, a soldering area can be increased by using the solder bridging characteristic.

FIG. 25 is a diagram of a packaging structure according to an embodiment of this application. Refer to FIG. 25. An embodiment of this application further provides a packaging structure 200, including at least one electronic component 210, a protective cover 220, and the substrate 100 shown above. The electronic component may be a bare chip or another functional component. There may be one or more electronic components 210. FIG. 25 uses one electronic component 210 as an example for description. The substrate 100 has an attachment region, the electronic component is fastened to the attachment region, the electronic component 210 is electrically connected to the substrate 100, and the protective cover 220 covers the substrate 100 to protect the electronic component 210.

It should be noted that, in FIG. 25, an example in which an enlarged pad needs to be designed on a surface that is of the substrate 100 and that is connected to a circuit board is used for description. It may be understood that, in another embodiment, an enlarged pad may alternatively be designed in the attachment region that is of the substrate 100 and that is connected to the electronic component 210.

Technical features of the substrate 100, technical effects achieved by the technical features, and implementation objectives achieved by the technical effects are the same as those of the substrate 100 shown above, and details are not described herein again.

An embodiment of this application further provides an electronic device, including a circuit board and the packaging structure 200 shown above. The packaging structure 200 is electrically connected to the circuit board.

Technical features of the substrate 100 included in the packaging structure, technical effects achieved by the technical features, and implementation objectives achieved by the technical effects are the same as those of the substrate 100 shown above, and details are not described herein again.

In the description of embodiments of this application, it should be noted that, unless otherwise explicitly stipulated and restricted, terms "installation", "joint connection", and "connection" should be understood broadly, which, for example, may be a fixed connection, or may be an indirect connection by using a medium, or may be internal communication between two components, or may be an interactive relationship between two components. A person of ordinary skill in the art may understand specific meanings of the foregoing terms in embodiments of this application based on specific cases.

In the specification, claims, and accompanying drawings of embodiments of this application, the terms "first", "second", "third", "fourth", and the like (if existent) are intended to distinguish between similar objects but do not necessarily indicate a specific order or sequence.

## Claims

1. A substrate (100), comprising:
a base body (110) and a barrier layer (120) disposed on a surface of the base body (110), wherein a first metal layer (130) and a plurality of second metal layers (140) arranged in an array are disposed between the base body (110) and the barrier layer (120), and the first metal layer (130) is disposed near at least a part of the second metal layers (140) on an outer side of the array;
a first hollow-out region (121) is provided at a position that is of the barrier layer (120) and that is opposite to the first metal layer (130), and at least a part of the first metal layer (130) is exposed in the first hollow-out region (121); and
a second hollow-out region (122) is provided at a position that is of the barrier layer (120) and that is opposite to each second metal layer (140), at least a part of the second metal layer (140) is exposed in the second hollow-out region (122), the second hollow-out regions (122) are separated from each other, and the first hollow-out region (121) is separated from an adjacent second hollow-out region (122),
wherein the barrier layer (120) has at least one barrier ring (123), the barrier ring (123) is located between the first hollow-out region (121) and the adjacent second hollow-out region (122), and the first hollow-out region (121) is separated from the adjacent second hollow-out region (122) by the barrier ring (123),
**characterized in that** the at least one barrier ring (123) is a semi-ring structure, and an inner side of the semi-ring structure and an arc-shaped side wall of the barrier layer (120) jointly enclose one second hollow-out region (122).

2. The substrate according to claim 1 , wherein the first metal layer (130) and at least one adjacent second metal layer (140) are connected and form an integrated structure.

3. The substrate according to claim 2, wherein the first metal layer (130) and two adjacent second metal layers (140) are connected and form an integrated structure.

4. The substrate according to claim 2, wherein the array is in a square shape, and the first metal layer (130) is disposed near a second metal layer (140) that is on an outermost side of the array and that is located at a corner; and
the first metal layer (130) and three adjacent second metal layers (140) are connected and form an integrated structure.

5. The substrate according to claim 2, wherein one first metal layer (130) is disposed on one side of each second metal layer (140) on an outermost side of the array, and the first metal layer (130) is located on one side that is of the second metal layer (140) on the outermost side and that faces outward.

6. The substrate according to claim 5, wherein the array is in a square shape, and an exposed area of a first metal layer (130) that is located on the outermost side of the array and that is located at a corner is greater than an exposed area of a first metal layer (130) at another position.

7. The substrate according to any one of claims 1 to 6, wherein a thickness of an annular wall of the barrier ring (123) is between 0.05 mm (2 mils) and 0.20 mm (8 mils).

8. The substrate according to any one of claims 1 to 7, wherein all the second hollow-out regions (122) have a same shape and an equal area.

9. A packaging structure (200), comprising at least one electronic component (210), a protective cover (220), and the substrate according to any one of claims 1 to 8, wherein
the substrate (100) has an attachment region, the electronic component (210) is fastened to the attachment region, the electronic component (210) is electrically connected to the substrate (100), and the protective cover (220) covers the substrate (100) to protect the electronic component (210).

10. An electronic device, comprising a circuit board (21) and the packaging structure (200) according to claim 9, wherein
the packaging structure (200) is electrically connected to the circuit board (21).

## Patentansprüche

1. Substrat (100), umfassend:
einen Grundkörper (110) und eine Barriereschicht (120), die auf einer Oberfläche des Grundkörpers (110) angeordnet ist, wobei eine erste Metallschicht (130) und eine Vielzahl von zweiten Metallschichten (140), die in einer Anordnung befindlich sind, zwischen dem Grundkörper (110) und der Barriereschicht (120) angeordnet sind und die erste Metallschicht (130) nahe mindestens eines Teils der zweiten Metallschichten (140) auf einer Außenseite der Anordnung angeordnet ist;
wobei ein erster Hohlbereich (121) an einer Position der Barriereschicht (120) bereitgestellt ist, die der ersten Metallschicht (130) gegenüberliegt, und mindestens ein Teil der ersten Metallschicht (130) in dem ersten Hohlbereich (121) freigelegt ist; und
wobei ein zweiter Hohlbereich (122) an einer Position der Barriereschicht (120) bereitgestellt ist, die jeder zweiten Metallschicht (140) gegenüberliegt, mindestens ein Teil der zweiten Metallschicht (140) in dem zweiten Hohlbereich (122) freigelegt ist, die zweiten Hohlbereiche (122) voneinander getrennt sind und der erste Hohlbereich (121) von einem angrenzenden zweiten Hohlbereich (122) getrennt ist,
wobei die Barriereschicht (120) mindestens einen Barrierering (123) aufweist, sich der Barrierering (123) zwischen dem ersten Hohlbereich (121) und dem angrenzenden zweiten Hohlbereich (122) befindet und der erste Hohlbereich (121) durch den Barrierering (123) von dem angrenzenden zweiten Hohlbereich (122) getrennt ist,
**dadurch gekennzeichnet, dass** der mindestens eine Barrierering (123) eine Halbringstruktur ist und eine Innenseite der Halbringstruktur und eine bogenförmige Seitenwand der Barriereschicht (120) gemeinsam einen zweiten Hohlbereich (122) umschließen.

2. Substrat nach Anspruch 1, wobei die erste Metallschicht (130) und mindestens eine angrenzende zweite Metallschicht (140) verbunden sind und eine integrierte Struktur bilden.

3. Substrat nach Anspruch 2, wobei die erste Metallschicht (130) und zwei angrenzende zweite Metallschichten (140) verbunden sind und eine integrierte Struktur bilden.

4. Substrat nach Anspruch 2, wobei die Anordnung quadratisch ist und die erste Metallschicht (130) nahe einer zweiten Metallschicht (140) angeordnet ist, die an einer äußersten Seite der Anordnung liegt und sich an einer Ecke befindet; und
die erste Metallschicht (130) und drei angrenzende zweite Metallschichten (140) verbunden sind und eine integrierte Struktur bilden.

5. Substrat nach Anspruch 2, wobei eine erste Metallschicht (130) auf einer Seite jeder zweiten Metallschicht (140) auf einer äußersten Seite der Anordnung angeordnet ist und sich die erste Metallschicht (130) auf einer Seite der zweiten Metallschicht (140) befindet, die auf der äußersten Seite liegt und nach außen gerichtet ist.

6. Substrat nach Anspruch 5, wobei die Anordnung quadratisch ist und eine freiliegende Fläche einer ersten Metallschicht (130), die sich an der äußersten Seite der Anordnung befindet und sich an einer Ecke befindet, größer als eine freiliegende Fläche einer ersten Metallschicht (130) an einer anderen Position ist.

7. Substrat nach einem der Ansprüche 1 bis 6, wobei eine Dicke einer ringförmigen Wand des Barriererings (123) zwischen 0,05 mm (2 mils) und 0,20 mm (8 mils) liegt.

8. Substrat nach einem der Ansprüche 1 bis 7, wobei alle zweiten Hohlbereiche (122) eine gleiche Form und eine gleiche Fläche aufweisen.

9. Verpackungsstruktur (200), umfassend mindestens eine elektronische Komponente (210), eine Schutzabdeckung (220) und das Substrat nach einem der Ansprüche 1 bis 8, wobei
das Substrat (100) einen Befestigungsbereich aufweist, die elektronische Komponente (210) an dem Befestigungsbereich angebracht ist, die elektronische Komponente (210) elektrisch mit dem Substrat (100) verbunden ist und die Schutzabdeckung (220) das Substrat (100) zum Schutz der elektronischen Komponente (210) abdeckt.

10. Elektronische Vorrichtung, umfassend eine Leiterplatte (21) und die Verpackungsstruktur (200) nach Anspruch 9, wobei
die Verpackungsstruktur (200) elektrisch mit der Leiterplatte (21) verbunden ist.

## Revendications

1. Substrat (100), comprenant :
un corps de base (110) et une couche barrière (120) disposée sur une surface du corps de base (110), dans lequel une première couche métallique (130) et une pluralité de secondes couches métalliques (140) agencées en réseau sont disposées entre le corps de base (110) et la couche barrière (120), et la première couche métallique (130) est disposée près d'au moins une partie des secondes couches métalliques (140) sur un côté extérieur du réseau ;
une première région évidée (121) est prévue à une position qui est celle de la couche barrière (120) et qui est opposée à la première couche métallique (130), et au moins une partie de la première couche métallique (130) est exposée dans la première région évidée (121) ; et
une seconde région évidée (122) est prévue à une position qui est celle de la couche barrière (120) et qui est opposée à chaque seconde couche métallique (140), au moins une partie de la seconde couche métallique (140) est exposée dans la seconde région évidée (122), les secondes régions évidées (122) sont séparées l'une de l'autre, et la première région évidée (121) est séparée d'une seconde région évidée adjacente (122),
dans lequel la couche barrière (120) possède au moins un anneau barrière (123), l'anneau barrière (123) est situé entre la première région évidée (121) et la seconde région évidée adjacente (122), et la première région évidée (121) est séparée de la seconde région évidée adjacente (122) par l'anneau barrière (123),
**caractérisé en ce que** l'au moins un anneau barrière (123) est une structure semi-annulaire, et un côté intérieur de la structure semi-annulaire et une paroi latérale en forme d'arc de la couche barrière (120) entourent conjointement une seconde région évidée (122).

2. Substrat selon la revendication 1, dans lequel la première couche métallique (130) et au moins une seconde couche métallique adjacente (140) sont reliées et forment une structure intégrée.

3. Substrat selon la revendication 2, dans lequel la première couche métallique (130) et deux secondes couches métalliques adjacentes (140) sont reliées et forment une structure intégrée.

4. Substrat selon la revendication 2, dans lequel le réseau est de forme carrée, et la première couche métallique (130) est disposée près d'une seconde couche métallique (140) qui se trouve sur un côté le plus externe du réseau et qui est située à un coin ; et
la première couche métallique (130) et trois secondes couches métalliques adjacentes (140) sont reliées et forment une structure intégrée.

5. Substrat selon la revendication 2, dans lequel une première couche métallique (130) est disposée sur un côté de chaque seconde couche métallique (140) sur un côté le plus externe du réseau, et la première couche métallique (130) est située sur un côté qui est celui de la seconde couche métallique (140) sur le côté le plus externe et qui est orienté vers l'extérieur.

6. Substrat selon la revendication 5, dans lequel le réseau est de forme carrée, et une surface exposée d'une première couche métallique (130) qui est située sur le côté externe du réseau et qui est située dans un coin est plus grande qu'une surface exposée d'une première couche métallique (130) à une autre position.

7. Substrat selon l'une quelconque des revendications 1 à 6, dans lequel l'épaisseur d'une paroi annulaire de l'anneau barrière (123) est comprise entre 0,05 mm (2 mils) et 0,20 mm (8 mils) .

8. Substrat selon l'une quelconque des revendications 1 à 7, dans lequel toutes les secondes régions évidées (122) ont une même forme et une surface égale.

9. Structure d'emballage (200) comprenant au moins un composant électronique (210), un couvercle de protection (220) et le substrat selon l'une quelconque des revendications 1 à 8, dans laquelle
le substrat (100) possède une région de fixation, le composant électronique (210) est fixé à la région de fixation, le composant électronique (210) est électriquement relié au substrat (100), et le couvercle de protection (220) recouvre le substrat (100) pour protéger le composant électronique (210).

10. Dispositif électronique comprenant une carte de circuit imprimé (21) et la structure d'emballage (200) selon la revendication 9, dans lequel
la structure d'emballage (200) est électriquement reliée à la carte de circuit imprimé (21).
